# EUROPÄISCHE PATENTSCHRIFT

(11) **EP 1 681 614 B1**
(45) Veröffentlichungstag und Bekanntmachung des Hinweises auf die Patenterteilung: **25.04.2007**
(21) Anmeldenummer: 06000166.6
(22) Anmeldetag: 05.01.2006
(51) Int. Cl.: G06F 1/18, H05K 7/14, H05K 5/00, H05K 5/02

(54) **Gehäuse zur Aufnahme von elektrischen Leiterkarten**
Housing for electrical circuit boards
Boîtier pour cartes à circuits électriques

(30) Priorität: 14.01.2005 DE 102005002138
(43) Veröffentlichungstag der Anmeldung: 19.07.2006
(73) Patentinhaber: Devolo AG, 52070 Aachen (DE)
(72) Erfinder: Schmettkordt, Michael, 6291 ND Vaals (NL)
(74) Vertreter: Kohlmann, Kai

(56) Entgegenhaltungen:
- EP-A- 0 943 860
- US-A- 5 383 793
- US-A- 5 457 608
- US-A- 5 754 406
- US-A- 5 996 962

## Beschreibung

Die Erfindung betrifft ein aus einem Gehäuseunterteil mit ebenem Gehäuseboden und einem Gehäuseoberteil zusammengesetztes Gehäuse zur Aufnahme von Leiterkarten mit einer Frontblende an der Gehäusevorderseite und einer Rückblende an der Gehäuserückseite, wobei die Front- und Rückblende lösbar mit dem Gehäuse verbunden sind.

Derartige aus Formteilen zusammengesetzte Gehäuse zur Aufnahme elektrischer Leiterkarten sind in unterschiedlichsten Formen und Größen aus dem Stand der Technik bekannt. Die den Gehäuseboden sowie das Gehäuseoberteil bildenden Formteile bestehen zumeist aus Kunststoff. Die Gehäuse nehmen Leiterkarten für die unterschiedlichsten Funktionen, beispielsweise für Datenkommunikationsgeräte auf. Die Leiterkarten weisen regelmäßig an ihrer Rückkante Schnittstellen, Stromversorgungsanschlüsse sowie Bedienelemente auf, die über mindestens eine eine Durchtrittsöffnung aufweisende Rückblende zugänglich sind. Die Rückblende befindet sich in einem Ausschnitt auf der Gehäuserückseite. An der gegenüberliegenden Gehäusevorderseite befindet sich eine Frontblende, die insbesondere transparent ausgeführt ist. Durch die Frontblende können Signalisierungsmittel an der Vorderkante der Leiterkarte, wie beispielsweise Leuchtdioden sichtbar gemacht werden, die beispielsweise die Funktionsbereitschaft des Datenkommunikationsgerätes anzeigen.

Angepasst an die Größe der jeweiligen elektrischen Leiterkarte, die von dem Gehäuse aufzunehmen ist, werden die bekannten Gehäuse in unterschiedlichen Größen gefertigt.

Da die Formteile des Gehäuses regelmäßig im Spritzgießverfahren hergestellt werden, muss für jede Gehäusegröße eine eigene Spritzform hergestellt werden, die bei geringen Stückzahlen des Gehäuses hohe Kosten für die Herstellung des Gehäuses verursacht.

Die US 5,996,962 A offenbart einen Halter zur Sicherung einer Einsteckkarte in einem Konnektor einer Hauptplatine eines Computers. Ein den Seitenrand der Leiterkarte aufnehmendes Halteelement weist einen Durchgang für ein verzahntes Profil auf. Das verzahnte Profil lässt sich mit einem äußeren, federnden Anschlag bis an die seitliche Gehäusewand des Computers ausziehen, ist jedoch in der entgegengesetzten Richtung arretiert. Infolge des derart gebildeten Anschlags wird die an der gegenüberliegenden Seite von dem Konnektor gehaltene Einsteckkarte daran gehindert, in Richtung der Seitenwand des Computergehäuses aus dem Schlitz des Konnektors herauszuwandern.

Die US 5,457,608 A betrifft eine Befestigungsvorrichtung, die die Unterbringung unterschiedlich großer Leiterkarten innerhalb eines Gehäuses ermöglicht, ohne dass das Gehäuse geändert werden muss. Die Befestigungsvorrichtung besteht aus einer am Gehäuse angebrachten Schiene mit paarweise auf gegenüberliegenden Seiten angeordneten Kerben. Auf dieser Schiene sind Haltemittel für die Leiterkarte verschieblich angeordnet. Die Haltemittel lassen sich in Richtung der Kante der Leiterkarte längs der Schiene bewegen und verrasten mit an den Haltemittel angeordneten Armen in den Kerben der Schiene. Die Leiterkarte liegt mit ihren Randbereichen auf einer Teilfläche der Schiene auf, während ein abgewinkelter Flansch des Halteelementes die Karte im Randbereich übergreift.

Ausgehend von diesem Stand der Technik liegt der Erfindung die Aufgabe zugrunde, ein Gehäuse der eingangs erwähnten Art zu schaffen, das zur Aufnahme unterschiedlich großer Leiterkarten geeignet ist, wobei nicht nur die Aufnahme unterschiedlich breiter Leiterkarten, sondern auch die Aufnahme unterschiedlich langer Leiterkarten in dem Gehäuse möglich sein soll.

Diese Aufgabe wird durch die Merkmale des Anspruchs 1 gelöst.

Indem am Gehäuseboden Führungselemente für in Richtung der gegenüberliegenden seitlichen Kanten der Leiterkarte verschieb- und arretierbare Halteelemente angeordnet sind, die an den seitlichen Kanten der Leiterkarte zur Anlage bringbar sind und mit einem Schenkel auf der Oberfläche der Leiterkarte im Bereich von deren seitlichen Kante aufliegen, erlaubt das erfindungsgemäße Gehäuse die Aufnahme unterschiedlich breiter Leiterkarten, das heißt von Leiterkarten, deren seitliche Kanten einen unterschiedlichen Abstand zueinander aufweisen. Die Leiterkarte ruht an ihrer Vorderkante auf einer Auflage, die benachbart zu dem Ausschnitt für die Frontblende angeordnet ist, während sie an ihrer Rückkante von einer Aufnahme gehalten wird, die an der Rückblende angeordnet ist.

Sowohl die Auflage an der Vorderkante als auch die Aufnahme an der Rückkante stehen lediglich mit einem Rand von etwa 3 bis 6 mm der Leiterkarte in Kontakt, so dass hierdurch die Bestückung der Leiterkarte nicht beeinträchtigt wird. Die erforderliche seitliche Fixierung der unterschiedlich breiten Leiterkarten erfolgt dadurch, dass am Gehäuseboden die Führungselemente für die in Richtung der gegenüberliegenden seitlichen Kanten der Leiterkarte verschieb- und arretierbaren Halteelemente angeordnet sind.

Die Durchtrittsöffnungen in der lösbar mit den übrigen Gehäuseteilen verbundene Rückblende sind vorzugsweise auf die jeweilige Leiterkarte abgestimmt.

Sowohl die Auflage für die Vorderkante als auch die Aufnahme für die Rückkante der Leiterkarte sind vorzugsweise in der selben Höhe angeordnet, so dass sich die Leiterkarte parallel zum Gehäuseboden befindet.

Die Höhe der Führungselemente für die Halteelemente ist vorzugsweise etwas geringer als die der Auflage sowie der Aufnahme für die Leiterkarte, um eine Beeinträchtigung der Leiterbahn sowie etwaiger an der Unterseite der Leiterkarte angeordneter Bauteile durch die Führungselemente zu vermeiden.

Die Front- und Rückblende des Gehäuses wird von Ausschnitten im Gehäuseober- und -unterteil aufgenommen.

Um nicht nur unterschiedlich breite, sondern auch unterschiedlich lange Leiterkarten in dem Gehäuse unterbringen zu können, ist es gemäß der Erfindung vorgesehen, dass die lösbare Rückblende eine senkrecht zum Gehäuseboden stehende Rückwand sowie zwei parallel zu dem Gehäuseboden verlaufende ebene Schenkel aufweist. Von der unteren Kante der Rückwand erstreckt sich parallel zu dem Gehäuseboden in Richtung des Gehäuseinneren ein ebener unterer Schenkel. Von der oberen Kante der Rückwand erstreckt sich parallel zu dem Gehäuseboden in entgegengesetzter Richtung zu dem unteren Schenkel ein ebener oberer Schenkel. Der untere Schenkel wird durch mindestens einen Anschlag auf dem Gehäuseboden in einer definierten Position zum Gehäuseboden fixiert und der obere Schenkel reicht bis an den Rand des Ausschnitts für die Rückblende in dem Gehäuseoberteil heran und sorgt damit für einen dichten Abschluss des Gehäuses.

Je nach Länge des unteren Schenkels der austauschbaren Rückblende verändert sich der Abstand der senkrecht zum Gehäuseboden stehenden Rückwand zu der Auflage für die Vorderkante der Leiterkarte. An der Rückwand der Rückblende ist erfindungsgemäß mindestens eine Aufnahme für die Rückkante der Leiterkarte angeordnet, so dass sich durch Einsetzen einer an die Länge der Leiterkarte angepassten Rückblende das Gehäuse universell einsetzen lässt.

Bei kürzeren Leiterkarten ist es zweckmäßig, wenn die Rückblende den Ausschnitt aus dem Gehäuse nicht nur nach oben verschließt, sondern auch in dem Bereich zwischen der Rückwand und dem Rand des Ausschnitts in dem Gehäuse. Erfindungsgemäß wird dies bei einer Rückblende, deren Rückwand und zumindest deren oberer Schenkel als gleichlange Rechtecke ausgeführt sind, dadurch gelöst, dass deren seitlichen Kanten jeweils über eine Abschlusswand miteinander verbunden sind.

Ein bevorzugtes an dem Gehäuseboden geführtes Halteelement zeichnet sich dadurch aus, dass das Halteelement eine federnd gelagerte Rastnase aufweist, die mit einer auf dem Gehäuseboden angeordneten Zahnleiste zusammenwirkt. Die Zahnleiste kann insbesondere unmittelbar beim Spritzgießvorgang in dem Gehäuseboden eingebracht werden. Sie ist insbesondere zwischen zwei Winkelprofilen angeordnet, deren freie Schenkel unter Ausbildung eines Schlitzes zueinander weisen. Das Halteelement wird von den Winkelprofilen geführt und weist einen sich durch den Schlitz erstreckenden Abschnitt auf, an dem der auf der Oberfläche der Leiterkarte zur Auflage bringbare Schenkel angeordnet ist.

Der Vorteil des erfindungsgemäßen Halteelements mit einer federnd gelagerten Rastnase, dass mit einer auf dem Gehäuseboden angeordneten Zahnleiste zusammenwirkt, besteht darin, dass dieses problemlos in Richtung der seitlichen Kanten der Leiterkarte verschoben und damit auf dessen Breite angepasst werden kann. Gleichzeitig wird auf einfache Art und Weise eine Arretierung der Halteelemente erreicht, in dem die Zahnflanken der Zähne der Zahnleiste in Einschubrichtung schräg und entgegen der Einschubrichtung senkrecht stehen und die Rastnase des Halteelementes in Einschubrichtung eine senkrechte Fläche und entgegen der Einschubrichtung eine schräge Fläche aufweist, wobei die schrägen Flächen der federnd gelagerten Rastnase und der Zahnflanken in Einschubrichtung des Halteelements aufeinander abgleiten, während entgegen der Einschubrichtung die senkrechten Flächen der Zähne an der senkrechten Fläche der Rastnase zur Anlage gelangen und damit wirksam ein Verschieben des Halteelementes entgegen der Einschubrichtung verhindern.

Die Erfindung betrifft auch ein Set nach Anspruch 6.

Nachfolgend wird die Erfindung anhand der Figuren näher erläutert.

Es zeigen
- Figur 1: eine Explosionsdarstellung eines erfindungsgemäßen Gehäuses,
- Figur 2: ein Gehäuseunterteil des Gehäuses nach Figur 1,
- Figur 3: das Gehäuseunterteil nach Figur 2 mit eingesetzter Rückblende für eine lange Leiterkarte,
- Figur 4: das Gehäuseunterteil nach Figur 3 mit eingesetzter langer Leiterkarte,
- Figur 5: ein Gehäuseunterteil nach Figur 2 mit einer abweichenden Rückblende für eine gegenüber Figur 4 kürzere Leiterkarte,
- Figur 6: ein Gehäuseunterteil nach Figur 2 mit einer abweichenden Rückblende für eine gegenüber Figur 5 kürzere Leiterkarte
- Figur 7a: eine perspektivische Ansicht der Oberseite eines Halteelementes für die Leiterkarten,
- Figur 7b: eine perspektivische Unteransicht des Halteelementes nach Figur 7a sowie
- Figur 8: eine vergrößerte Darstellung der Führungselemente für eine Halteelement nach Figur 7a,b.

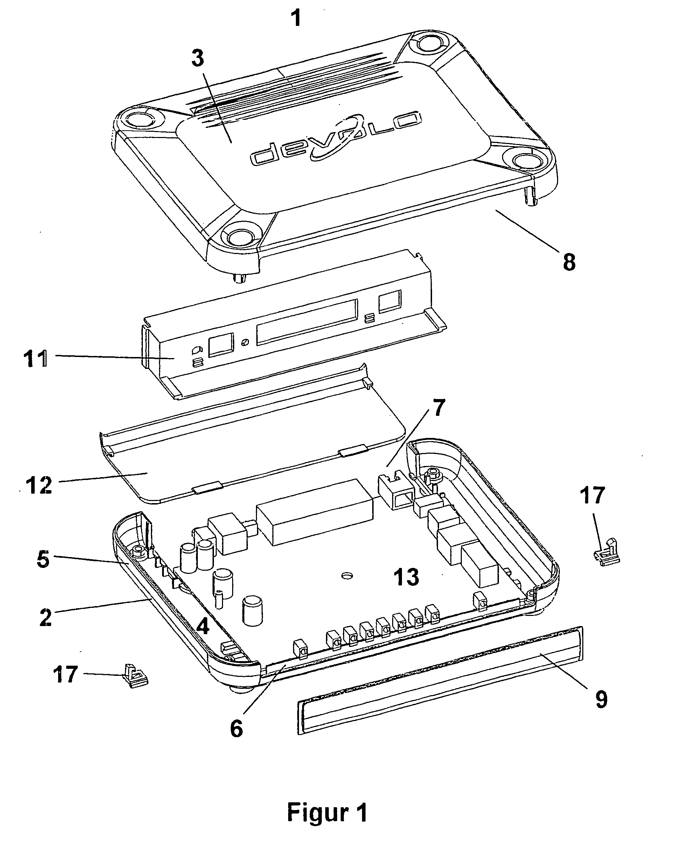

Aus der Explosionszeichnung nach Figur 1 ist der grundsätzliche Aufbau des erfindungsgemäßen Gehäuses erkennbar:
Das insgesamt mit 1 bezeichnete Gehäuse wird aus einem Gehäuseunterteil 2 und einem Gehäuseoberteil 3 zusammengesetzt. Sowohl bei dem Gehäuseunterteil 2 als auch dem Gehäuseoberteil 3 handelt es sich um Kunststoffformteile, die im Spritzgießverfahren hergestellt werden. Der ebene Gehäuseboden 4 des Gehäuseunterteils 2 wird seitlich von einem umlaufenden Rand 5 begrenzt, der an der Vorderseite von einem Ausschnitt 6 und an der Rückseite von einem Ausschnitt 7 unterbrochen wird. Der Ausschnitt 6 an der Vorderseite des Gehäuseunterteils 2 dient in Verbindung mit einem entsprechenden Ausschnitt 8 an der Vorderseite des Gehäuseoberteils 3 zur Aufnahme einer Frontblende 9.
Der Ausschnitt 7 an der Rückseite dient im Zusammenhang mit einem in Figur 1 nicht erkennbaren Ausschnitt an der Rückseite des Gehäuseoberteils 3 zur Aufnahme einer Rückblende 11. Ferner wird der bis in den Gehäuseboden 4 hineinreichende Ausschnitt 7 teilweise von einer lösbar mit dem Gehäuseunterteil 2 verbundenen Abdeckung 12 verschlossen. Die herausnehmbare Abdeckung 12 dient dem Zweck, den Zugang zu den Schnittstellen sowie Bedienelementen an der Rückwand der Rückblende 11 zu erleichtern.

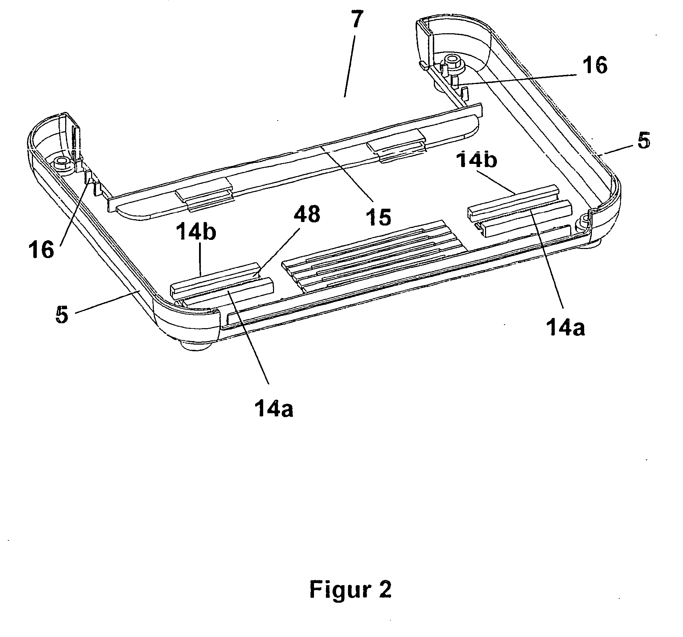

Schließlich ist in Figur 1 die von dem Gehäuse aufgenommene Leiterkarte 13 dargestellt, die in unterschiedlicher Größe von ein und demselben Gehäuse 1 aufgenommen werden kann. Die hierfür erforderlichen Halte- und Führungselemente sowie Aufnahmen und Auflagen werden nachfolgend anhand der Figuren 2 bis 8 näher erläutert:

Figur 2 zeigt das erfindungsgemäße Gehäuseunterteil 2. Nahe dem umlaufenden Rand 5 befinden sich im Bereich des Ausschnitts 6 an der Vorderseite jeweils links und rechts zwei Führungselemente 14a, 14b zur Aufnahme der in Figur 2 nicht dargestellten Halteelemente 17 für die Leiterkarte 13. Ferner ist aus Figur 2 eine den Ausschnitt 7 an der Rückseite des Gehäuseunterteils 2 begrenzende Anschlagleiste 15 erkennbar. Seitlich wird der Ausschnitt 7 von Vorsprüngen 16, die am Gehäuseboden 4 angeformt sind, begrenzt.

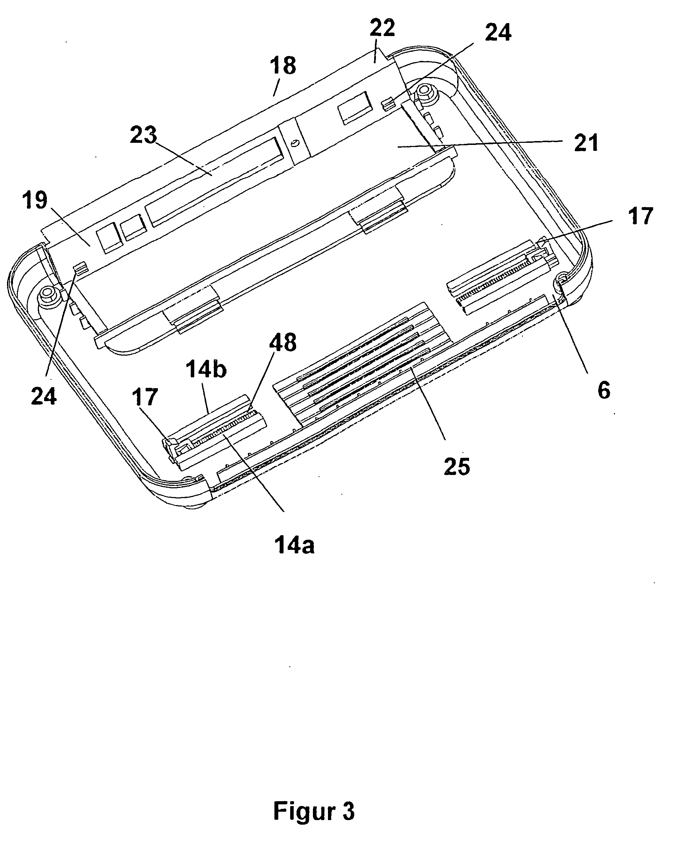

Figur 3 zeigt das Gehäuseunterteil 2 nach Figur 2 mit eingesetzten Halteelementen 17, sowie mit eingesetzter Rückblende 18 für eine lange Platine. Die Rückblende 18 besteht aus einer senkrecht zum Gehäuseboden 4 stehenden Rückwand 19, von deren unterer Kante sich parallel zu dem Gehäuseboden in Richtung des Gehäuseinneren ein ebener unterer Schenkel 21 erstreckt. Von der oberen Kante der Rückwand 19 erstreckt sich parallel zu dem Gehäuseboden 4 in entgegengesetzter Richtung ein oberer Schenkel 22. Die Rückwand 19 der Rückblende 18 weist in an sich bekannter Weise Durchtrittsöffnungen 23 für die Konnektoren der Schnittstellen der Leiterkarten sowie den Stromanschluss und ggf. an der Rückseite vorgesehene Bedienelemente auf. Des weiteren befinden sich an der dem Gehäuseinneren zugewandten Seite der Rückwand 19 zwei Aufnahmen 24 für die Rückkante der Leiterkarte. Die Aufnahmen werden durch zwei parallel zueinander, sich senkrecht von der Rückwand 19 erstreckende Stege gebildet, deren Abstand der Dicke der Leiterkarte entspricht, so dass diese zwischen den Stegen der Aufnahmen 24 eingeklemmt wird.

Nahe dem Ausschnitt 6 an der Vorderseite des Gehäuseunterteils 2 befindet sich eine rechteckig profilierte Auflage 25 für die Vorderkante 27 der Leiterkarte 13. Weiter ist aus Figur 3 erkennbar, wie der untere Schenkel 21 der Rückblende 18 durch die Anschlagleiste 15 sowie die Vorsprünge 16 in einer definierten Position zum Gehäuseboden 4 fixiert wird.

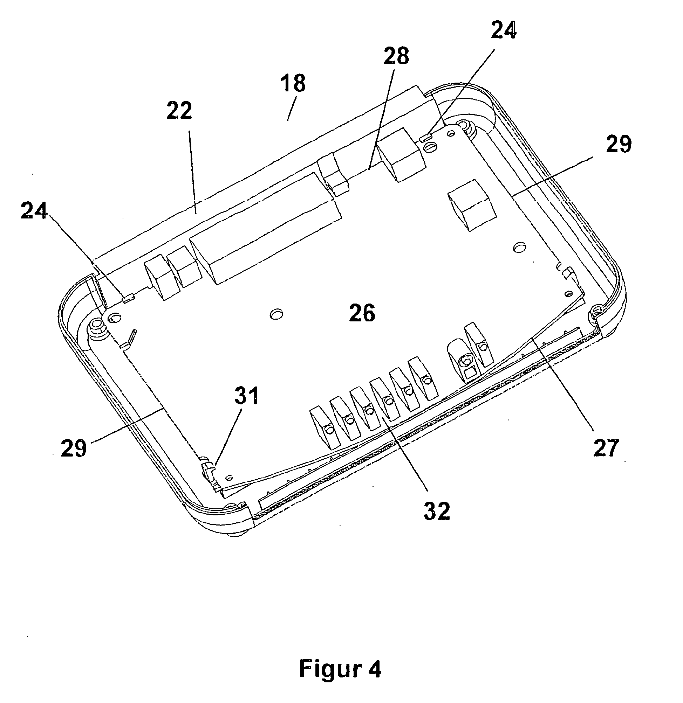

Figur 4 zeigt das Gehäuseunterteil nach Figur 3 mit eingesetzter langer Leiterkarte 26. Die Leiterkarte 26 weist eine gebogene Vorderkante 27 und gegenüberliegend eine gradlinig verlaufende Rückkante 28 sowie zwei seitliche Kanten 29 auf.

Aus Figur 4 ist deutlich erkennbar, dass die Vorderkante 27 in einem mittleren Bereich auf der Auflage 25 aufliegt, während die gradlinige Rückkante 28 zwischen den Stegen der Aufnahmen 24 an der Rückwand 19 der Rückblende 18 eingeklemmt ist. Die seitlichen Kanten 29 der Leiterkarte 26 werden von den Halteelementen 17 in ihrer Lage fixiert. Aus Figur 4 ist weiter erkennbar, dass die Halteelemente 17 an den seitlichen Kanten 29 anliegen und jeweils mit einem Schenkel 31 auf der Oberfläche der Leiterkarte 26 aufliegen.

Schließlich sind an der Vorderkante 27 der Leiterkarte 26 mehrere Leuchtdioden 32 zur Signalisierung des Betriebszustandes angeordnet, die durch die transparente Frontblende 9 erkennbar sind.

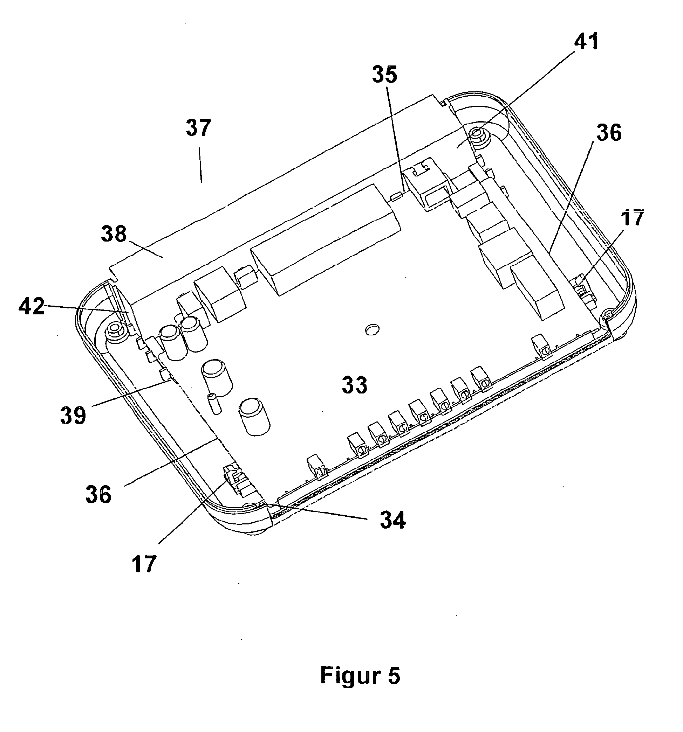

Figur 5 zeigt das Gehäuseunterteil 2 nach Figur 1, jedoch mit einer gegenüber der Leiterkarte 26 nach Figur 4 kürzeren Leiterkarte 33, die sowohl an der Vorder- als auch der Rückkante 34, 35 gradlinig ausgebildet ist. Die Halteelemente 17 liegen übereinstimmend wie bei der Leiterkarte in Figur 4 an deren seitlichen Kanten 36 an. Die Vorderkante 34 der Leiterkarte 33 liegt über ihrer vollen Länge auf der Auflage 25 auf, während die Rückkante 35 von den Aufnahmen 24 der Rückblende 37 aufgenommen wird. Die Rückblende 37 unterscheidet sich von der Rückblende 18 nach Figur 3, 4 dadurch, dass der obere Schenkel 38 länger als der obere Schenkel 22 und der untere Schenkel 39 kürzer als der untere Schenkel 21 der Rückblende 18 ist. Die Summe der Schenkellängen 38, 39 der Rückblende 37 entspricht allerdings der Summe der Schenkellängen 21, 22 der Rückblende 18 mit dem Ergebnis, dass stets der vollständige Ausschnitt 7 an der Rückseite durch die Rückblende verschlossen wird, jedoch die Rückwand 19, 41 einen unterschiedlichen Abstand zum Ausschnitt 6 an der Vorderseite und damit zur Auflage 25 aufweist.

Die seitlichen Kanten des oberen Schenkel 38 sowie der Rückwand 41 der Rückblende 37 sind seitlich durch eine Abschlusswand 42 miteinander verbunden, um das Gehäuse 1 auch seitlich vollständig zu verschließen, wenn die Rückwand 41, wie in Figur 5 gezeigt, weiter in das Gehäuseinnere verlagert ist, um eine kürzere Leiterkarte 33 aufzunehmen.

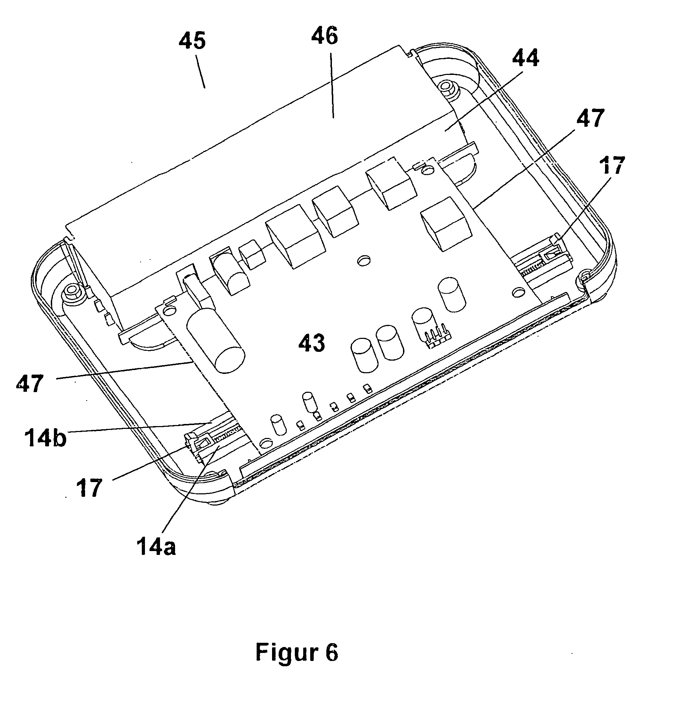

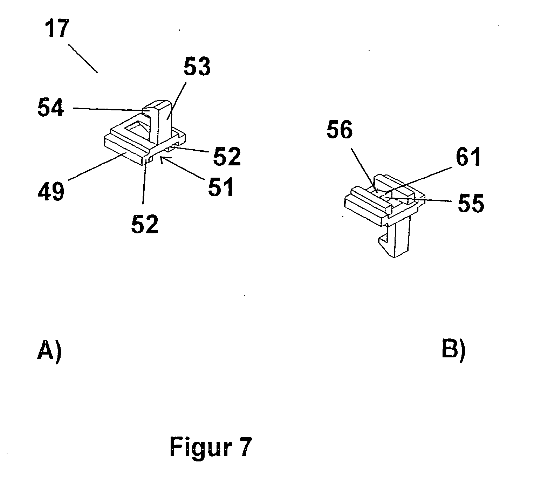

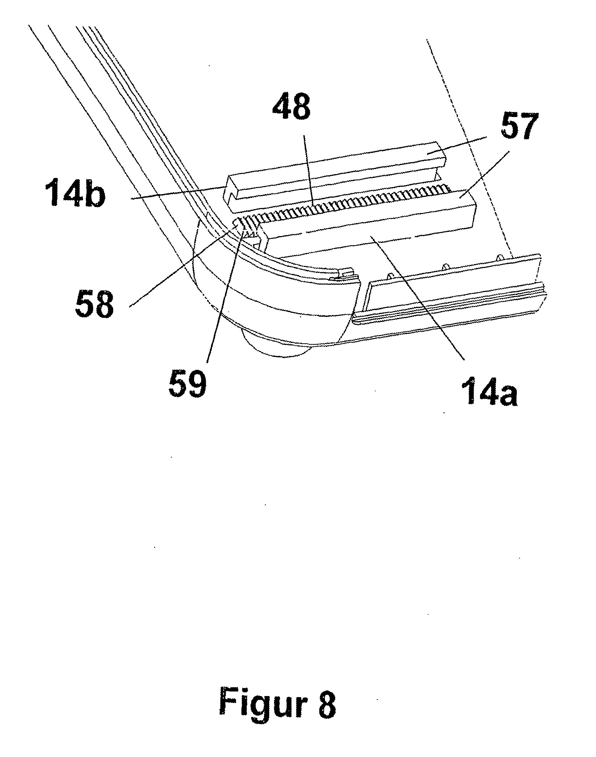

Figur 6 zeigt schließlich eine noch kürzere Leiterkarte 43 als die in Figur 5 dargestellte Leiterkarte 33. Erkennbar ist, dass die Rückwand 44 der Rückblende 45 bis an die Anschlagleiste 15 heranreicht. Im Ergebnis ist die Länge des unteren Schenkels auf Null reduziert, während der obere Schenkel 46 der Rückblende 45 sich bis an de Rand des Ausschnitts 7 an der Rückseite des Gehäuses erstreckt. Die Leiterkarte 43 ist jedoch nicht nur kürzer als die übrigen dargestellten Leiterkarten 33, 26, sondern weist darüber hinaus eine geringere Breite, das heißt einen geringeren Abstand zwischen ihren seitlichen Kanten 47 auf. Zur seitlichen Fixierung der Leiterkarte 43 ist es daher erforderlich, die Halteelemente 17 aus ihrer in Figur 6 dargestellten Ausgangsposition in den Führungen 14a, 14b in Richtung der seitlichen Kanten 47 zu verschieben, bis sie dort zur Anlage gelangen. Die Arretierung der Halteelemente 17 in der Anlageposition an den seitlichen Kanten 47 erfolgt mittels eines Rastmechanismus zwischen den Halteelementen 17 und einer zwischen den Führungselementen 14a, 14b angeordneten Zahnleiste 48, der näher anhand der Figuren7, 8 erläutert wird:

Das insgesamt mit 17 bezeichnete Halteelement besteht aus einem Grundkörper 49, der beispielsweise quaderförmig ist und dessen Oberfläche im Einsatz des Halteelementes parallel zum Gehäuseboden 4 ausgerichtet ist. An der Unterseite des Grundkörpers 49 befinden sich zwei parallel zur Einschubrichtung 51 des Halteelementes 17 beabstandete Gleitkufen 52. Der Abstand zwischen den Gleitkufen entspricht zumindest der Breite der Zahnleiste 48, die mittels der Gleitkufen 52 und dem Grundkörper 49 überbrückt wird. An dem in Einschubrichtung 51 hinteren Rand des Grundkörpers 49 ist ein senkrechter Abschnitt 53 angeordnet, der an seiner Oberseite den Auflageschenkel 54 aufweist, der auf der Oberfläche der Leiterkarte 13, 26, 33, 43 im Bereich von deren seitlichen Kanten 29 aufliegt, sobald das Halteelement 17 in den Führungen 14a, 14b an den seitlichen Kanten 29 zur Anlage gebracht worden ist. Im Bereich zwischen den Gleitkufen 52 besitzt der Grundkörper 49 eine federnd gelagerte Rastnase 55. Die Federwirkung wird von einem an den Grundkörper 49 angeformten Abschnitt 56 ausgeübt.

Das Halteelement 17 wirkt nun mit den Führungselementen 14a, 14b sowie der Zahnleiste 48 wie folgt zusammen:

Das Halteelement 17 wird in der in Figur 7a dargestellten Orientierung in Einschubrichtung 51 in die Führung 14a, 14b eingeschoben, wobei der Grundkörper 49 unterhalb der freien Schenkel der Führungselemente 14a, 14b zu liegen kommt. Die Gleitkufen 52 befinden sich auf der linken bzw. rechten Seite der Zahnleiste 48. Der senkrechte Abschnitt 53 ragt durch den von den freien Schenkeln 57 ausgebildeten Schlitz nach oben, wobei der Auflageschenkel 54 in Richtung der Seitenkanten der Leiterkarte 13, 26, 33, 43 weist. Die Zahnflanken 58 der Zähne 59 der Zahnleiste 48 stehen in Einschubrichtung 51 schräg, während sie entgegen der Einschubrichtung senkrecht zur Gehäuseoberfläche ausgerichtet sind. Die Zahnflanken der ebenfalls als Zahn ausgebildeten Rastnase 55 des Halteelements sind entgegengesetzt orientiert. Dies bedeutet, dass die Zahnflanke der Rastnase des Halteelements 17 in Einschubrichtung senkrecht zur Oberfläche des Gehäuses ausgerichtet ist und entgegen der Einschubrichtung eine schräge Fläche aufweist. Die schräge Zahnflanke 61 der Rastnase 55 gleitet daher auf den schräg gestellten Zahnflanken 58 der Zähne 59 der Zahnleiste 48 in Einschubrichtung 51 ab. Entgegen der Einschubrichtung 51 lässt sich das Halteelement 17 nach einem Verschieben in Einschubrichtung 51 nicht mehr bewegen, da dann die senkrecht stehenden Zahnflanken von Rastnase 55 und den Zähnen 59 der Zahnleiste aneinander anliegen und eine Bewegung des Halteelements 17 verhindern. Im Ergebnis wird durch den vorstehend beschriebenen Mechanismus die erfindungsgemäße Verschieb- und Arretierbarkeit des Halteelements 17 auf einfache Art gewährleistet. Selbstverständlich liegt es im Rahmen der Erfindung andere Arretiermechanismen, wie beispielsweise Klemmmechanismen und dergleichen vorzusehen, um die verschieblich angeordneten Halteelemente in der gewünschten Position zu arretieren.

### Bezugszeichenliste

| Nr. | Bezeichnung | Nr. | Bezeichnung |
|---|---|---|---|
| 1. | Gehäuse | 29. | seitliche Kanten |
| 2. | Gehäuseunterteil | 30. | ----- |
| 3. | Gehäuseoberteil | 31. | Schenkel |
| 4. | Gehäuseboden | 32. | Leuchtdioden |
| 5. | umlaufender Rand | 33. | Leiterkarte |
| 6. | Ausschnitt Vorderseite | 34. | Vorderkante |
| 7. | Ausschnitt Rückseite | 35. | Rückkante |
| 8. | Ausschnitt | 36. | seitliche Kanten |
| 9. | Frontblende | 37. | Rückblende (mittlere Leiterkarte) |
| 10. | ------ | 38. | oberer Schenkel |
| 11. | Rückblende | 39. | unterer Schenkel |
| 12. | Abdeckung | 40. | ------ |
| 13. | Leiterkarte | 41. | Rückwand |
| 14. a,b | Führungselement | 42. | Abschlusswand |
| 15. | Anschlag | 43. | Leiterkarte |
| 16. | Vorsprünge | 44. | Rückwand |
| 17. | Halteelement | 45. | Rückblende (kurze Leiterkarte) |
| 18. | Rückblende (lange Leiterkarte) | 46. | oberer Schenkel |
| 19. | Rückwand | 47. | seitliche Kanten |
| 20. | -------- | 48. | Zahnleiste |
| 21. | unterer Schenkel | 49. | Grundkörper |
| 22. | oberer Schenkel | 50. | ------- |
| 23. | Durchtrittsöffnungen | 51. | Einschubrichtung |
| 24. | Aufnahmen | 52. | Gleitkufen |
| 25. | Auflage | 53. | senkrechter Abschnitt |
| 26. | Leiterkarte (lang) | 54. | Auflageschenkel |
| 27. | Vorderkante | 55. | Rastnase |
| 28. | Rückkante | 56. | plattenförmiger Abschnitt |
| | | 57. | freie Schenkel |
| | | 58. | Zahnflanken |
| | | 59. | Zähne |
| | | 60. | ----- |
| | | 61. | Zahnflanken |

## Patentansprüche

1. Aus einem Gehäuseunterteil mit ebenem Gehäuseboden und einem Gehäuseoberteil zusammengesetztes Gehäuse zur Aufnahme von Leiterkarten mit einer Frontblende an der Gehäusevorderseite und einer Rückblende an der Gehäuserückseite, wobei die Front- und Rückblende lösbar mit dem Gehäuse verbunden sind, **dadurch gekennzeichnet, dass**
- die in dem Gehäuse (1) angeordnete Leiterkarte (13) mit ihrer Vorderkante(27) in Richtung der Frontblende (9), mit ihrer Rückkante (28) in Richtung der Rückblende (11) und mit den seitlichen Kanten(29) in Richtung des seitlichen Randes (5) des Gehäuseoberteils (3) und des Gehäuseunterteils (2) weist
- am Gehäuseboden (4) des Gehäuseunterteils (2) mindestens eine Auflage (25) für die Vorderkante (27) der Leiterkarte (13) benachbart zu einem Ausschnitt (6) für die Frontblende (9) angeordnet ist,
- an der Rückblende (11) mindestens eine Aufnahme (24) für die Rückkante (28) der Leiterkarte (13) angeordnet ist,
- am Gehäuseboden (4) Führungselemente (14a,b) für in Richtung der gegenüberliegenden seitlichen Kanten (29) der Leiterkarte (13) verschieb- und arretierbare Halteelemente (17) angeordnet sind, die an den seitlichen Kanten der Leiterkarte (13) zur Anlage bringbar sind und mit einem Schenkel (31) auf der Oberfläche der Leiterkarte (13) im Bereich von deren seitlichen Kanten (29) aufliegen,
- das Gehäuseunterteil (2) einen umlaufenden Rand (5) aufweist, der an der Gehäusevorderseite von dem Ausschnitt (6) zur Aufnahme der Frontblende (9) und an der Gehäuserückseite von einem Ausschnitt (7) zur Aufnahme der Rückblende (11) unterbrochen ist,
- das Gehäuseoberteil (3) einen umlaufenden Rand aufweist, der an der Gehäusevorderseite von einem Ausschnitt (8) zur Aufnahme der Frontblende (9) und an der Gehäuserückseite von einem Ausschnitt zur Aufnahme der Rückblende (11) unterbrochen ist,
- die Front- und Rückblende (9,11) des Gehäuses (1) lösbar mit dem Gehäuseoberteil (3) und dem Gehäuseunterteil (2) verbunden sind,
- die Rückblende (11) eine senkrecht zum Gehäuseboden (4) stehende Rückwand (19) sowie zwei parallel zu dem Gehäuseboden (4) verlaufende ebene Schenkel(21,22) aufweist,
- sich von der unteren Kante der Rückwand (19) parallel zu dem Gehäuseboden (4) in Richtung des Gehäuseinneren ein ebener unterer Schenkel (21) erstreckt und
- sich von der oberen Kante der Rückwand (19) parallel zu dem Gehäuseboden (4) in entgegengesetzter Richtung zu dem unteren Schenkel (21) ein ebener oberer Schenkel (22) erstreckt und
- der untere Schenkel (21) durch mindestens einen Anschlag (15) auf dem Gehäuseboden (4) in einer definierten Position zum Gehäuseboden fixiert wird und
- der obere Schenkel (22) bis an den Rand des Ausschnitts in dem Gehäuseoberteil heranreicht.

2. Gehäuse nach Anspruch 1, **dadurch gekennzeichnet, dass** die Rückwand (19) und zumindest der obere Schenkel (22) der Rückblende (11) als gleichlange Rechtecke ausgeführt sind, deren seitliche Kanten jeweils über eine Abschlusswand (42) miteinander verbunden sind.

3. Gehäuse nach Anspruch 1 oder 2, **dadurch gekennzeichnet, dass** das Halteelement (17) eine federnd gelagerte Rastnase(55) aufweist, die mit einer auf dem Gehäuseboden angeordneten Zahnleiste (48) zusammenwirkt.

4. Gehäuse nach Anspruch 3, **dadurch gekennzeichnet, dass** die Zahnleiste (48) zwischen zwei Winkelprofilen (14a, 14b) angeordnet ist, deren freie Schenkel (57) unter Ausbildung eines Schlitzes zueinander weisen, das Halteelement (17) von den Winkelprofilen geführt wird und das Halteelement einen sich durch den Schlitz erstreckenden Abschnitt (53) aufweist, an dem der auf der Oberfläche der Leiterkarte zur Auflage bringbare Schenkel (54) angeordnet ist.

5. Gehäuse nach Anspruch 3 oder 4, **dadurch gekennzeichnet, dass** die Zahnflanken (58) der Zähne (59) der Zahnleiste (48) in Einschubrichtung (51) schräg und entgegen der Einschubrichtung senkrecht stehen und die Rastnase (55) des Halteelementes (17) in Einschubrichtung (51) eine senkrechte Fläche und entgegen der Einschubrichtung eine schräge Fläche (61) aufweist, wobei die schräge Fläche der federnd gelagerten Rastnase (55) und der Zahnflanken (58) in Einschubrichtung des Halteelements (17) aufeinander abgleiten.

6. Set umfassend ein Gehäuse (1) nach einem der Ansprüche 1 bis 5 sowie mindestens zwei Rückblenden (11, 18, 37, 45) mit unterschiedlich langen oberen und unteren Schenkeln (21,22,38,39), wobei die Summe der Schenkellängen sämtlicher Rückblenden übereinstimmt.

## Claims

1. A housing composed of a lower housing part having a flat housing floor and of an upper housing part, to receive circuit cards with a front frame on the front side of the housing and with a rear frame on the rear side of the housing, the front and rear frames being releasably joined to the housing, **characterized in that**
- the circuit card (13) which is arranged in the housing (1) points with its front edge (27) in the direction of the front frame (9), and with its rear edge (28) in the direction of the rear frame (11), and with the lateral edges (29) in the direction of the lateral rim (5) of the upper housing part (3) and of the lower housing part (2),
- at least one support (25) is arranged on the housing floor (4) of the lower housing part (2) for the front edge (27) of the circuit card (13) adjacent to a cutout (6) for the front frame (9),
- at least one mounting (24) is provided on the rear frame (11) for the rear edge (28) of the circuit card (13),
- guide elements (14a,b) are arranged on the housing floor (4) for holding elements (17) which are displaceable and arrestable in the direction of the opposite lateral edges (29) of the circuit card (13), said holding elements (17) being able to be brought into abutment against the lateral edges of the circuit card (13), and resting with an arm (31) on the surface of the circuit card (13) in the region of its lateral edges (29),
- the lower housing part (2) has an encircling rim (5) which is interrupted on the front side of the housing by the cutout (6) to receive the front frame (9) and on the rear side of the housing by a cutout (7) to receive the rear frame (11),
- the upper housing part (3) has an encircling rim which is interrupted on the front side of the housing by a cutout (8) to receive the front frame (9) and on the rear side of the housing by a cutout to receive the rear frame (11),
- the front and rear frames (9, 11) of the housing (1) are releasably joined to the upper housing part (3) and the lower housing part (2),
- the rear frame (11) has a rear wall (19) standing perpendicular to the housing floor (4), and two flat arms (21,22) running parallel to the housing floor (4),
- a flat lower arm (21) extends from the lower edge of the rear wall (19) parallel to the housing floor (4) in the direction of the interior of the housing and
- a flat upper arm (22) extends from the upper edge of the rear wall (19) parallel to the housing floor (4) in the opposite direction to the lower arm (21)
- the lower arm (21) is fixed by at least one stop (15) on the housing floor (4) in a defined position to the housing floor and
- the upper arm (22) reaches up to the rim of the cutout in the upper housing part.

2. The housing according to Claim 1, **characterized in that** the rear wall (19) and at least the upper arm (22) of the rear frame (11) are constructed as rectangles of equal length, the lateral edges of which are respectively connected with each other by a closure wall (42).

3. The housing according to Claim 1 or 2, **characterized in that** the holding element (17) has an elastically mounted detent nose (55) which cooperates with a toothed strip (48) arranged on the housing floor.

4. The housing according to Claim 3, **characterized in that** the toothed strip (48) is arranged between two angle sections (14a, 14b), the free arms (57) of which point towards each other, forming a slit, the holding element (17) is guided by the angle profiles and the holding element has a portion (53) extending through the slit, on which the arm (54) is arranged which is able to be brought to rest on the surface of the circuit card.

5. The housing according to Claim 3 or 4, **characterized in that** the tooth flanks (58) of the teeth (59) of the toothed strip (48) stand obliquely in the insertion direction (51) and perpendicularly contrary to the insertion direction, and the detent nose (55) of the holding element (17) has a perpendicular surface in the insertion direction (51) and an oblique surface (61) contrary to the insertion direction, the oblique surface of the elastically mounted detent nose (55) and of the tooth flanks (58) gliding on each other in the insertion direction of the holding element (17).

6. A set comprising a housing (1) according to any of Claims 1 to 5 and at least two rear frames (11, 18, 37, 45) having upper and lower arms (21, 22, 38, 39) of differing length, the sum of the arm lengths coinciding with all the rear frames.

## Revendications

1. Boîtier pour cartes à circuits imprimés composé d'une partie inférieure de boîtier comportant une base de boîtier plate et une partie supérieure de boîtier, avec un panneau avant sur le côté avant du boîtier et un panneau arrière sur le côté arrière du boîtier, moyennant quoi les panneaux avant et arrière sont reliés de manière amovible au boîtier, **caractérisé en ce que**
- la carte à circuit électrique (13) disposée dans le boîtier (1) est dirigée par son arête avant (27) dans le sens du panneau avant (9), par son arête arrière (28) dans le sens du panneau arrière (11) et par ses arêtes latérales (29) dans le sens du bord latéral (5) de la partie supérieure du boîtier (3) et de la partie inférieure du boîtier (2),
- sur la base de boîtier (4) de la partie inférieure du boîtier (2), au moins une surface d'appui (35) destinée à l'arête avant (27) de la carte à circuit électrique (13) est disposée à proximité d'une découpe (6) destinée au panneau avant (9),
- sur le panneau avant (11), au moins un réceptacle (24) destiné à l'arête arrière (28) de la carte à circuit imprimé (13) est disposé,
- sur la base de boîtier (4), des éléments de guidage (14a,b) destinés à des éléments de maintien (17) déplaçables et arrêtables dans le sens des arêtes latérales opposées (29) de la carte à circuit imprimé (13) sont disposés, lesquels peuvent être amenés en appui sur les arêtes latérales de la carte à circuit électrique (13) et reposent par un pan (31) sur la surface supérieure de la carte à circuit électrique (13) au niveau de leurs arêtes latérales (29),
- la partie inférieure du boîtier (2) présente un bord périphérique (5), qui est interrompu sur le côté avant du boîtier par une découpe (6) pour recevoir le panneau avant (9) et sur le côté arrière du boîtier par une découpe (7) pour recevoir le panneau arrière (11),
- la partie supérieure du boîtier (3) présente un bord périphérique, qui est interrompu sur le côté avant du boîtier par une découpe (8) pour recevoir le panneau avant (9) et sur le côté arrière du boîtier par une découpe pour recevoir le panneau arrière (11),
- les panneaux avant et arrière (9,11) du boîtier (1) sont reliés de manière amovible à la partie supérieure du boîtier (3) et à la partie inférieure du boîtier (2),
- le panneau arrière (11) présente une paroi arrière (19) dressée perpendiculairement à la base du boîtier (4) ainsi que deux pans (21,22) plats s'étendant parallèlement à la base du boîtier (4),
- un pan inférieur plat (21) s'étend à partir de l'arête inférieure de la paroi arrière (19) parallèlement à la base du boîtier (4) dans le sens de l'intérieur du boîtier et
- un pan supérieur plat (22) s'étend à partir de l'arête supérieure de la paroi arrière (19) parallèlement à la base du boîtier (4) dans le sens contraire par rapport au pan inférieur (21) et
- le pan inférieur (21) est fixé par au moins une butée (15) sur la base du boîtier (4) dans une position définie par rapport à la base du boîtier et
- le pan supérieur (22) arrive jusqu'au bord de la découpe dans la partie supérieure du boîtier.

2. Boîtier selon la revendication 1, **caractérisé en ce que** la paroi arrière (19) et au moins le pan supérieur (22) du panneau arrière (11) sont réalisés comme des rectangles de même longueur, dont les arêtes latérales sont respectivement reliées les unes aux autres par une paroi de fermeture (42).

3. Boîtier selon la revendication 1 ou 2, **caractérisé en ce que** l'élément de maintien (17) présente un nez d'encliquetage (55) positionné par ressort, qui coopère avec une barrette dentée (48) disposée sur la base du boîtier.

4. Boîtier selon la revendication 3, **caractérisé en ce que** la barrette dentée (48) est disposée entre deux profils d'angle (14a,14b), dont les pans libres (57) sont dirigés l'un vers l'autre en formant une fente, l'élément de maintien (17) est inséré par les profils d'angle et l'élément de maintien présente une section (53) s'étendant à travers la fente, sur laquelle le pan (54) pouvant être amené en appui sur la surface de la carte à circuit électrique est disposé.

5. Boîtier selon la revendication 3 ou 4, **caractérisé en ce que** les flancs de dent (58) des dents (59) de la barrette dentée (48) sont obliques dans le sens d'insertion (51) et se dressent perpendiculairement dans le sens contraire du sens d'insertion et le nez d'encliquetage (55) de l'élément de maintien (17) présente dans le sens d'insertion (51) une surface perpendiculaire et dans le sens contraire au sens d'insertion une surface oblique (61), moyennant quoi la surface oblique du nez d'encliquetage (55) positionné par ressort et des flancs de dents (58) glissent l'une sur l'autre dans le sens d'insertion de l'élément de maintien (17).

6. Kit comprenant un boîtier (1) selon une des revendications 1 à 5 ainsi que au moins deux panneaux arrières (11,18/37,45) comportant des pans supérieurs et inférieurs (21,22,38,39) de longueurs différentes, moyennant quoi la somme des longueurs des pans de tous les panneaux arrières concorde.
